# EUROPEAN PATENT SPECIFICATION

(11) **EP 3 141 826 B1**
(45) Date of publication and mention of the grant of the patent: **06.06.2018**
(21) Application number: 15866367.4
(22) Date of filing: 27.02.2015
(51) Int. Cl.: F24F 1/20, F24F 1/24, F24F 11/02, H01L 23/34

(54) **AIR CONDITIONER CONTROL SYSTEM AND AIR CONDITIONER CONTROL METHOD**
KLIMAANLAGENSTEUERUNGSSYSTEM UND KLIMAANLAGENSTEUERUNGSVERFAHREN
SYSTÈME ET PROCÉDÉ DE COMMANDE DE CONDITIONNEUR D'AIR

(43) Date of publication of application: 15.03.2017
(73) Proprietor: Mitsubishi Electric Corporation, Chiyoda-ku Tokyo 100-8310 (JP)
(72) Inventor: HAMAMOTO, Wataru, Tokyo 100-8310 (JP)
(74) Representative: Pfenning, Meinig & Partner mbB
(86) International application number: PCT/JP2015/055972
(87) International publication number: WO 2016/135976

(56) References cited:
- JP-A- H05 172 373
- JP-A- 2006 135 186
- JP-A- 2009 170 605
- JP-A- 2010 287 734
- JP-A- 2010 287 734
- JP-A- 2011 163 728
- JP-A- 2012 059 037
- JP-A- 2014 005 947
- JP-A- 2014 005 947
- JP-A- 2014 122 737

## Description

### Field

The present invention relates to an air-conditioner control system and a control method for an air conditioner and, more particularly, to an air conditioner system including a temperature control function used under a low-temperature environment such as a cold region.

### Background

Some air conditioner placed outdoors has been sometimes used under a low-outdoor-temperature environment such as a cold region. Under such a low-temperature environment, an electronic component such as a microcomputer mounted on a board assembly (ASSY), that is, a board assembly mounted component is sometimes used at temperature lower than a guarantee temperature of a component manufacturer. The electronic component is likely to cause a malfunction.

Therefore, Patent Literature 1 discloses a technique for, when a component is used in a range in which an ambient temperature is lower than a manufacturer guarantee temperature of the component, after turning on a power supply of an air conditioner, warming, with a heater or another heat generating component mounted on a board, the target component having the ambient temperature lower than the manufacturer guarantee temperature and performing control for switching the air conditioner to a normal operation mode when the ambient temperature of the target component rises to be equal to or higher than a fixed temperature according to a temperature sensor disposed in the vicinity of the target component. Moreover, Patent Literature 2 discloses a control system suitable for being used in an electronic apparatus, especially in an electronic apparatus which is present in a low-temperature environment.

### Citation List

### Patent Literature

Patent Literature 1: Japanese Patent Application Laid-Open No. 2014-5947
Patent Literature 2: JP 2006 135186 A

### Summary

### Technical Problem

However, according to the conventional technology, when the board assembly mounted component is used in the range in which the ambient temperature is lower than the manufacturer guarantee temperature of the component, after a power supply of the air conditioner is turned on, the target component having the ambient temperature lower than the manufacturer guarantee temperature is warmed by the heat generating component, and the control for switching the air conditioner to the normal operation mode when the ambient temperature of the target component rises to be equal to or higher than the fixed temperature is performed. Therefore, no problem occurs if the ambient temperature of the target component does not fall below the temperature guarantee temperature of the target component. However, in the case of the configuration explained above, in a board assembly with less heat generation during normal operation, the ambient temperature is likely to fall below the manufacturer guarantee temperature during the operation.

The present invention has been devised in view of the above and it is an object of the present invention to obtain an air-conditioner control system in which a target component can always be used within a guarantee temperature range of a manufacturer while an air conditioner is in normal operation.

### Solution to Problem

In order to solve the above problem, and in order to attain the above object, an air-conditioner control system of the present invention includes: an air conditioner main body including an air conditioning function; a power-supply circuit unit; a control board mounted with an electronic component including a microcomputer for control; a temperature sensor that measures temperature of the electronic component; and a temperature control unit that heats, during normal operation, on the basis of a measurement value of the temperature sensor, the electronic component such that operation is performed at temperature equal to or higher than a guarantee temperature of the electronic component.

### Advantageous Effects of Invention

According to the present invention, there is an effect that the target component can always be used within the guarantee temperature range of the manufacturer while the air conditioner is in the normal operation.

### Brief Description of Drawings

FIG. 1 is a conceptual diagram showing a board assembly of an air-conditioner control system in a first embodiment.
FIG. 2 is a diagram showing the air-conditioner control system in the first embodiment.
FIG. 3 is a flowchart for explaining a control method in the air-conditioner control system in the first embodiment.
FIG. 4 is a conceptual diagram showing a board assembly of an air-conditioner control system in a second embodiment.
FIG. 5 is a diagram showing the air-conditioner control system in the second embodiment.
FIG. 6 is a flowchart for explaining a control method in the air-conditioner control system in the second embodiment.
FIG. 7 is a temperature graph showing a flow of operation in the air-conditioner control system in the second embodiment.
FIG. 8 is a time chart showing a flow of operation in an air-conditioner control system in a third embodiment.

### Description of Embodiments

Air-conditioner control systems and control methods for air conditioners according to embodiments of the present invention are explained in detail below with reference to the drawings. Note that the present invention is not limited by the embodiments.

### First Embodiment.

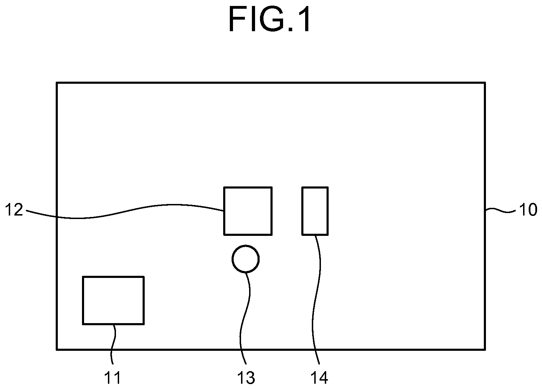

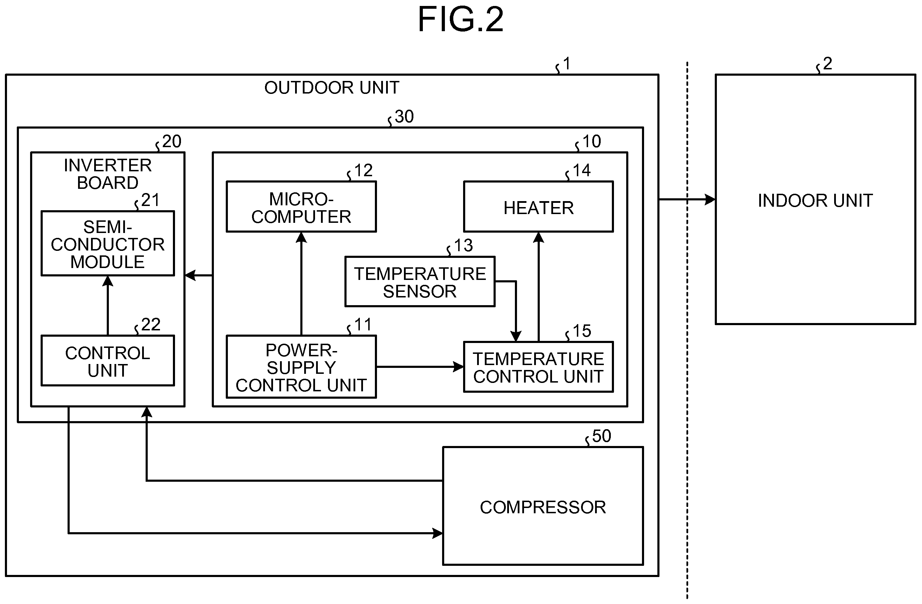

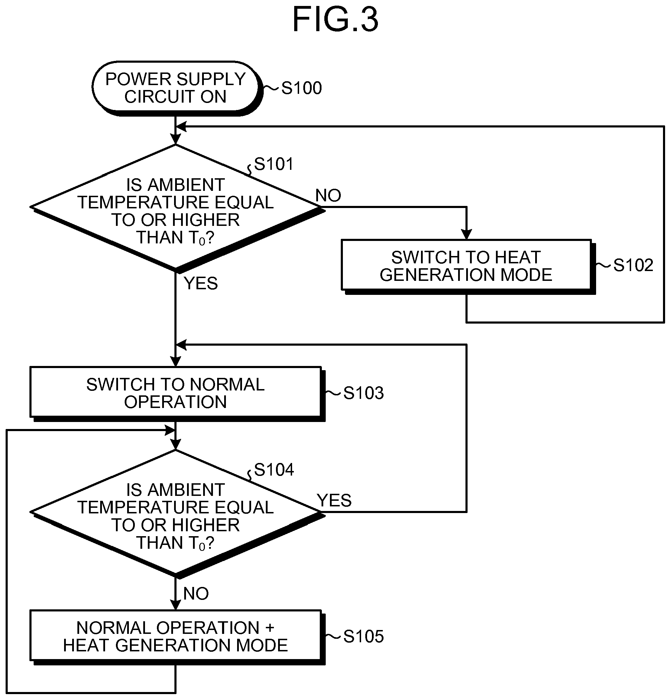

FIG. 1 is a conceptual diagram showing a board assembly of a control board used in an air-conditioner control system in a first embodiment. FIG. 2 is a diagram showing the air-conditioner control system in the first embodiment. FIG. 3 is a flowchart for explaining a control method in the air-conditioner control system in the first embodiment. The control board of the air-conditioner control system in this embodiment controls an air conditioner without a malfunction under a low-temperature environment lower than a manufacturer guarantee temperature of an electronic component such as a microcomputer 12. The control board 10 in this embodiment is mounted with a power-supply circuit unit 11 and the microcomputer 12 connected to the power-supply circuit unit 11 and includes a temperature sensor 13 that detects an ambient temperature of the microcomputer 12 and a heater 14 that heats the microcomputer 12. The control board 10 always detects the ambient temperature of the microcomputer 12 after the power-supply circuit unit 11 of an outdoor unit 1, which is an air conditioner main body, changes to an ON state and, when the ambient temperature is about to fall below the manufacturer guarantee temperature, automatically performs control to warm the target component and always keeps the ambient temperature within a manufacturer guarantee temperature range.

The air-conditioner control system in the first embodiment includes, as shown in FIG. 2, the outdoor unit 1, which is the air conditioner main body set outdoors and including an air conditioning function and a control function, and an indoor unit 2. The outdoor unit 1 includes the control board 10 mounted with the power-supply circuit unit 11, electronic components including the microcomputer 12 for control, and the temperature sensor 13 that measures the temperature of the electronic components, an inverter board 20, and a compressor 50 driven by the inverter board 20. In the air-conditioner control system, during normal operation, a temperature control unit 15 performs temperature control on the basis of a measurement value of the temperature sensor 13 such that operation is performed at temperature equal to or higher than a guarantee temperature of the microcomputer 12.

In the outdoor unit 1, the control board 10, which is a board assembly, shown in FIG. 1 is disposed. In the control board 10, an electronic component such as the microcomputer 12, temperature of which falls below a guarantee temperature of a component manufacturer under a low-temperature environment, the temperature sensor 13 that detects the ambient temperature of the microcomputer 12, and the heater 14 that warms the microcomputer 12 to temperature equal to or higher than the manufacturer guarantee temperature are set. The temperature sensor 13 is mounted, adjacent to the microcomputer 12, on a printed wiring board that configures the control board 10. Note that the heater 14 can take any form and only has to be a heat generating body. The heater 14 can be a power supply IC (Integrated Circuit) for supplying electric power consumed by the control board 10. Details of the power supply IC are explained below in the second embodiment. The temperature sensor 13 can be a thermistor or can be a temperature sensor IC.

The first embodiment is based on the premise that the air-conditioner control system is applied to an air conditioner that performs variable speed control of the compressor 50 with the inverter board 20. A controller 30 is set in an upper part of the outdoor unit 1 of the air conditioner. The compressor 50 that compresses refrigerant is set in a lower part of the outdoor unit 1.

As shown in FIG. 2, the controller 30 controls the operation of the outdoor unit 1 including the compressor 50. The control board 10 mounted with the microcomputer 12, the temperature sensor 13, and the heater 14 and the inverter board 20 mounted with the semiconductor module 21 configuring an inverter for driving of the compressor 50 are housed in a box made of sheet metal. The outer side surface of the box made of sheet metal is covered with a not-shown cover made of sheet metal. When maintenance is performed, the cover is removed and a state of the board and the like is checked. Note that, in some case, electronic components other than the microcomputer 12 are also mounted on the control board 10 and guarantee temperatures of some electronic components are equal to or higher than the guarantee temperature of the microcomputer 12. In this embodiment, the microcomputer 12 is used while maintaining the ambient temperature of the microcomputer 12 to be equal to or higher than the manufacturer guarantee temperature of the microcomputer 12. However, when other electronic components, temperatures of which are likely to be lower than guarantee temperatures, are mounted, the temperatures of the electronic components are controlled to be equal to or higher than the guarantee temperature of the electronic component having the highest guarantee temperature. Note that, in the following explanation, the manufacturer guarantee temperature of the microcomputer is sometimes simply referred to as guarantee temperature.

On the control board 10, the microcomputer 12 and the power-supply circuit unit 11 that supplies electric power to the microcomputer 12 or the inverter board 20 are mounted. A program for controlling the operation of the air conditioner is stored in a memory of the microcomputer 12. The microcomputer 12 reads out the program and executes the program with a CPU (Central Processing Unit) to thereby control the operation of the outdoor unit 1.

The heater 14 is mounted in a region in the vicinity of the microcomputer 12 of the control board 10 where heat conduction or heat radiation is possible. Further, the temperature control unit 15 that controls driving of the heater 14 is mounted. The heater 14, which is a kind of a heat generating body, warms the microcomputer 12. The heater 14 generates heat with an electric current supplied from the power-supply circuit unit 11 via the temperature control unit 15.

On the inverter board 20, the semiconductor module 21 configuring the inverter for driving of the compressor 50 and a control unit 22 including an IC for control that controls the operation of the semiconductor module 21 are mounted. The semiconductor module 21 is configured by an IGBT (Insulated Gate Bipolar Transistor) or a diode, which is a switching element. A frequency output by the semiconductor module 21 changes according to a necessary refrigerant circulation amount.

The operation of the air-conditioner control system in the first embodiment is explained with reference to a flowchart of FIG. 3. After the power supply of the air conditioner is turned on and the power-supply circuit unit 11 is turned on at step S100, in the outdoor unit 1, at step S101, the temperature sensor 13 mounted on the control board 10 detects the temperature of a mounted position of the microcomputer 12, that is, the ambient temperature of a mounted position of the temperature sensor 13. The temperature control unit 15 determines whether the ambient temperature is equal to or higher than temperature T₀ higher than a guarantee temperature of a manufacturer. The temperature sensor 13 always performs temperature detection.

When it is determined at step S101 that the ambient temperature of the electronic component such as the microcomputer 12 is lower than the temperature T₀ higher than the guarantee temperature of the manufacturer, the air conditioner is switched to a heat generation mode at step S102. The temperature control unit 15 causes the heater 14 to generate heat and warms the electronic component such as the microcomputer 12. Thereafter, the operation returns to step S101 and the heat generation mode is maintained until the ambient temperature rises to be equal to or higher than the temperature T₀. Note that, concerning the setting of the temperature T₀, the temperature T₀ can be set during factory shipment or a user can be able to be optionally set the temperature T₀.

Thereafter, when the ambient temperature rises to be equal to or higher than the temperature T₀ at step S101, at step S103, the air conditioner is switched to a normal operation mode. Note that, until the ambient temperature rises to be equal to or higher than the temperature T₀, the microcomputer 12 sets the inverter board 20 of the air conditioner in a standby state and in a normal operation prohibited state. The normal operation means a state in which the inverter board 20 operates and performs operation control of the compressor 50. The normal operation includes both of a normal operation state and a normal stop state.

Thereafter, at step S104, the temperature control unit 15 determines again whether the ambient temperature is equal to or higher than the temperature T₀.

When the ambient temperature of the electronic component such as the microcomputer 12 is equal to or higher than the temperature T₀ higher than the guarantee temperature of the manufacturer at step S104, the operation returns to step S103 again. The microcomputer 12 actuates the inverter board 20. The inverter board 20 continues the normal operation during the normal operation and is set in the normal stop state during a normal stop.

On the other hand, when it is determined at step S104 that the ambient temperature falls below the temperature T₀, at step S105, the air conditioner is switched to a normal operation + heat generation mode in which the temperature control unit 15 performs heater heating while the normal operation is performed during the normal operation. Temperature control is performed until the ambient temperature rises to be higher than temperature T₀. Similarly, when it is determined at step S105 that the ambient temperature detected by the temperature sensor 13 during an operation stop in the normal operation mode falls below the temperature T₀, the temperature control unit 15 switches the air conditioner to the heat generation mode and performs control such that the ambient temperature rises to be higher than the temperature T₀.

After the air conditioner is switched to the normal operation + heat generation mode at step S105, the operation returns to step S104 again. The temperature control unit 15 determines whether the ambient temperature is equal to or higher than the temperature T₀.

Thereafter, while the power supply of the air conditioner is on, step S104 and step S105 explained above are repeated. Note that, concerning timing when the temperature sensor 13 detects the ambient temperature at the steps, the temperature sensor 13 always detects the ambient temperature.

As explained above, while the power supply of the air conditioner is on, the temperature sensor 13 always detects the ambient temperature of the electronic component such as the microcomputer 12. Consequently, it is possible to always use the components within a guarantee temperature range of a component manufacturer.

Even if the operation is stopped halfway, it is possible to immediately resume the operation because the temperature sensor 13 always detects the ambient temperature.

Note that, in some case, electronic components other than the microcomputer 12 are mounted on the control board 10 and some electronic components have guarantee temperatures equal to or higher than the guarantee temperature of the microcomputer 12 or the guarantee temperature of the semiconductor module 21 mounted on the inverter board 20 is higher than the guarantee temperature of the microcomputer 12.

For example, it is assumed that the guarantee temperature of the semiconductor module 21 mounted on the inverter board 20 is higher than the guarantee temperature of the microcomputer 12. For example, after the power-supply circuit unit is turned on, the temperature control unit 15 supplies an electric current to the heater 14 from the power-supply circuit unit 11 and heats the microcomputer 12 to thereby raise the temperature of the microcomputer 12 to a first temperature. When the temperature of the microcomputer 12 exceeds the first temperature, the temperature control unit 15 energizes the microcomputer 12 from the power-supply circuit unit 11 to set the microcomputer in an operable state. ON and OFF of the semiconductor module 21 are alternately repeated according to control of the microcomputer 12 to raise the temperature of the semiconductor module 21 to a second temperature determined in advance. When the temperature of the semiconductor module 21 exceeds the second temperature, the control of the semiconductor module 21 can be determined to be capable of being shifted to control of the normal operation. By performing processing in two stages in this way, it is possible to realize control with higher reliability.

Note that, concerning the timing when the temperature sensor 13 detects the ambient temperature, the temperature sensor 13 always detects the ambient temperature as explained above. However, the detection timing can be changed as appropriate. For example, a detection interval of the detection of the ambient temperature by the temperature sensor 13 can be set during factory shipment or the user can be able to optionally set the detection interval.

### Second Embodiment.

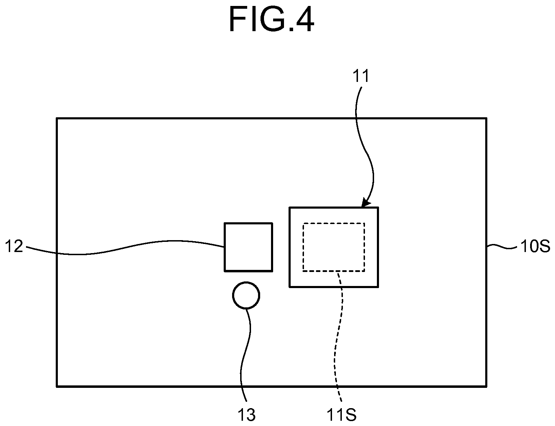

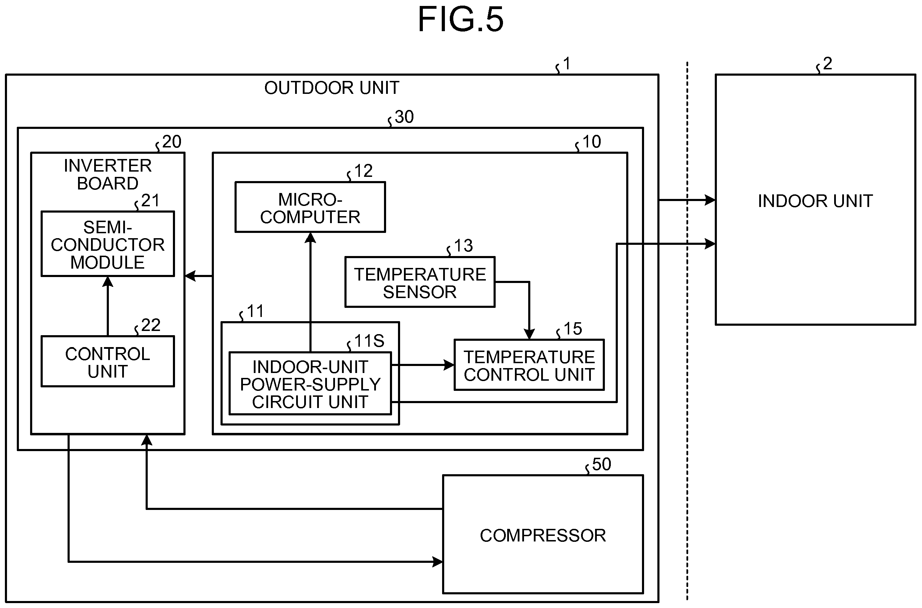

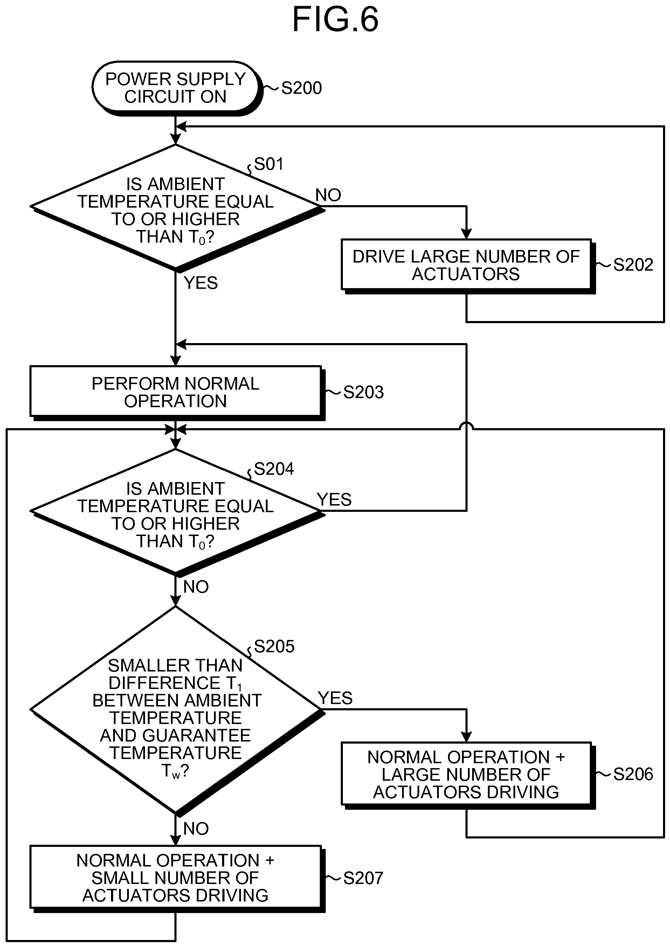

In the first embodiment, the heater 14 itself for control board heating is controlled to switch the air conditioner to the heat generation mode. However, in a second embodiment, the heater 14 is not separately provided. A load of the indoor unit 2 connected to the outdoor unit 1 is adjusted to cause the power-supply circuit unit 11 to generate heat and warm the electronic component such as the microcomputer 12. FIG. 4 is a conceptual diagram showing a board assembly of a control board used in a control unit of an air-conditioner control system in the second embodiment. FIG. 5 is a diagram showing the air-conditioner control system in the second embodiment. FIG. 6 is a flowchart for explaining a control method in the air-conditioner control system in the second embodiment. On the control board 10S, which is a board assembly of the outdoor unit 1, the heater 14 for heating the microcomputer 12 is absent. In the power-supply circuit unit 11, in a circuit that supplies electric power to the indoor unit 2, a large number of actuators are operated and a driving current is increased to cause a power supply IC, which configures an indoor-unit power-supply circuit unit 11S of the power-supply circuit unit 11, to generate heat and warm the microcomputer 12. Components other than the indoor-unit power-supply circuit unit 11S for heating the microcomputer 12 are the same as the components in the first embodiment. Therefore, explanation of the components is omitted.

The operation of the air-conditioner control system in the second embodiment is explained with reference to the flowchart of FIG. 6. First, when a power supply of an outdoor air conditioner is turned on and the power-supply circuit unit 11 is turned on at step S200, at step S201, as in the first embodiment, the temperature control unit 15 determines on the basis of a detection value of the temperature sensor 13 whether the ambient temperature of the electronic component such as the microcomputer 12 is equal to or higher than the temperature T₀ higher than the guarantee temperature of the manufacturer. In this embodiment, as in the first embodiment, the temperature sensor 13 always performs temperature detection.

When it is determined at step S201 that the ambient temperature of the electronic component such as the microcomputer 12 is lower than the temperature T₀ higher than the guarantee temperature of the manufacturer, at step S202, the temperature control unit 15 operates the larger number of actuators of the indoor unit 2 connected to the outdoor unit 1 and causes the indoor unit 2 to consume an electric current larger than an electric current in the normal state to thereby cause the indoor-unit power-supply circuit unit 11S, which supplies electric power to the indoor unit, in the power-supply circuit unit 11 to generate heat.

Thereafter, the operation returns to step S201. If the ambient temperature is equal to or higher than the temperature T₀, at step S203, the microcomputer 12 drives the inverter board 20 and switches the control unit 22 to the normal operation mode or the normal stop state. Note that, as in the first embodiment, the air conditioner is set in the standby state and set in the normal operation prohibited state until the ambient temperature rises to be equal to or higher than the temperature T₀.

Thereafter, at step S204, the temperature control unit 15 determines on the basis of a detection value of the temperature sensor 13 whether the ambient temperature of the electronic component such as the microcomputer 12 is equal to or higher than the temperature T₀ higher than the guarantee temperature of the manufacturer.

If the ambient temperature of the electronic component such as the microcomputer 12 is equal to or higher than the temperature T₀ higher than the guarantee temperature of the manufacturer at step S204, the inverter board 20 continues the normal operation. The normal operation includes the normal operation state and the normal stop state.

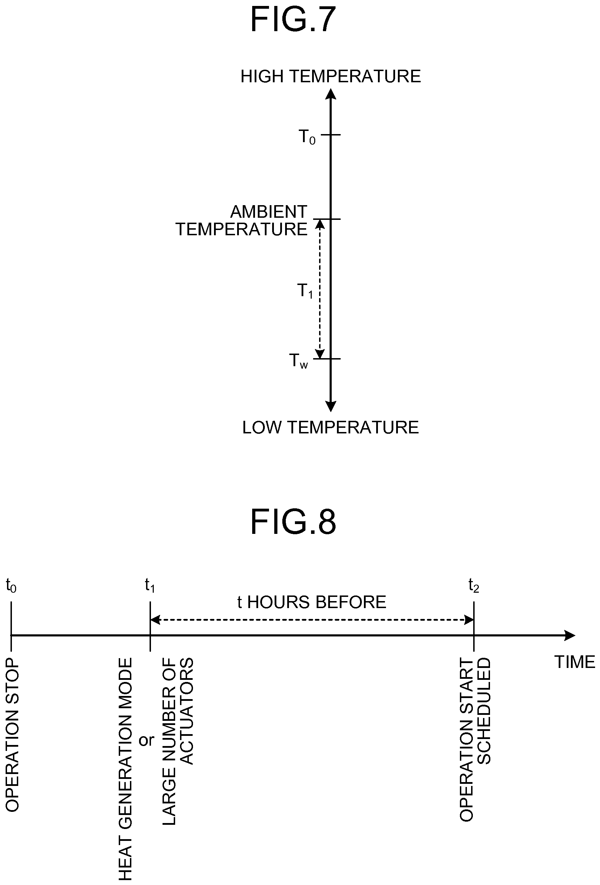

When the ambient temperature is lower than the temperature T₀ at step S204, the operation shifts to step S205. As shown in the temperature graph of FIG. 7, if a difference between the ambient temperature and a guarantee temperature T_{w} is smaller than T₁, the operation shifts to step S206. In addition to the normal operation or the stop, for example, the temperature control unit 15 operates an un-operated actuator such as a vane motor of the indoor unit 2 connected to the outdoor unit 1 or increases the number of revolutions of a fan motor to increase a load to thereby cause the indoor-unit power-supply circuit unit 11S to generate heat and raises the ambient temperature to be equal to or higher than the temperature T₀.

Thereafter, at step S204, the temperature control unit 15 checks again whether the ambient temperature is equal to or higher than the temperature T₀. The temperature difference T₁ can be set during factory shipment or the user can optionally set the temperature difference T₁.

On the other hand, when the temperature control unit 15 determines at step S205 that the difference between the ambient temperature and the guarantee temperature T_{w} is equal to or larger than the temperature T₁, the operation shifts to step S207. As at step S206, in addition to the normal operation or stop, the temperature control unit 15 performs operation for increasing a consumed current of the indoor unit 2 connected to the outdoor unit 1. When there is an un-operated actuator such as a vane motor and the number of revolutions of the fan motor is few, the operation is performed by, for example, increasing the number of revolutions to increase the number of actuators in an operation state and increase the number of revolutions of the fan motor to increase a load. The ambient temperature is raised to be equal to or higher than the temperature T₀. However, compared with step S206, the number of the actuators to be operated or the load is reduced. The number of actuators operated at step S206 and step S207 and an amount of the load can be set during factory shipment or the user can be able to optionally set the number of actuators and the amount of the load. After the number of actuators to be operated is increased or the load is increased at step S207, the operation returns to step S204 again. The temperature control unit 15 determines and checks at step S204 whether the ambient temperature is equal to or higher than the temperature T₀.

Thereafter, while the power supply of the air conditioner is on, steps S204 to S207 explained above are repeated.

Note that, concerning timing when the temperature sensor 13 detects the ambient temperature at the steps can be set during factory shipment or the user can be able to optionally set the timing.

As explained above, while the power supply of the air conditioner is on, the temperature sensor 13 always detects the ambient temperature of the microcomputer 12 alone or the electronic components around the microcomputer 12. Consequently, it is possible to always use the components within the guarantee temperature range of the component manufacturer.

Even if the operation is stopped halfway, the temperature sensor 13 always detects the ambient temperature. Therefore, it is possible to immediately resume the operation.

### Third Embodiment.

In the first and second embodiments, the temperature sensor 13 always detects the ambient temperature even during the operation stop. The control is performed to raise the ambient temperature to be equal to or higher than the temperature T₀ such that the operation can be immediately resumed. However, excess electric power always continues to be consumed to raise the ambient temperature. Therefore, in a third embodiment, control for suppressing power consumption during an operation stop is carried out. In this embodiment, the air conditioner includes an operation reservation timer for reserving operation time. During the operation stop, the temperature detection of the electronic component by the temperature sensor 13 is stopped. Control is performed to raise the temperature of the electronic component such as the microcomputer 12 to be equal to or higher than the guarantee temperature at the time reserved for operation. A time chart showing a method in the third embodiment is shown in FIG. 8.

As shown in FIG. 8, the operation is stopped at time t₀, which is a point in time of the operation stop. Timer reservation is performed during the operation stop. At time t₁, which is t hours before an operation start scheduled time t₂, the air conditioner is switched to the heat generation mode at step S102 in FIG. 3 or the large number of actuators such as the vane motor or the fan motor of the indoor unit 2 connected to the outdoor unit 1 are operated at step S202 in FIG. 6 to consume a lot of electric current to thereby cause the indoor-unit power-supply circuit unit 11S, which supplies a power supply voltage to the indoor unit 2, to generate heat. The ambient temperature is raised such that the normal operation can be performed at the scheduled time t₂, which is t hours after time t₁. Time t₁ can be set during factory shipment or the user can be able to optionally set time t₁. At time t₁, which is t hours before the operation start scheduled time t₂, the ambient temperature is detected by the temperature sensor 13, the power generation mode at step S102 in FIG. 3 or time for starting the operation at step S202 in FIG. 6 can be automatically changed. Only the temperature control of the control board 10 is performed in advance. Consequently, it is possible to realize surer operation control.

As explained above, by performing the timer reservation during the operation stop, it is possible to suppress power consumption during the operation stop.

Note that the vane motor is a motor in which an air motor unit configured from a rotor incorporating several vanes and a housing and a planetary gear reduction device, that is, a planetary reduction gear that transmits an output to a shaft are integrally incorporated. The motor can obtain a high output. The fan motor is a motor that press-feeds the air with a propeller present in an annular channel between cylindrical hub casings and generates wind in a rotation axis direction of the propeller. The fan motor can obtain a large air quantity with a compact structure. Therefore, the fan motor is suitable for use of ventilation and cooling for cooling the entire inside of an apparatus. In an air conditioner, the fan motor and the vane motor are often used in combination. However, in the temperature control unit 15, heat generation by the indoor-unit power-supply circuit unit 11S including power supply to the fan motor and the vane motor is used as a heating unit for compensation of the control board 10. That is, it is possible to control, with the heat generation by the indoor-unit power-supply circuit unit 11S, the temperature of the electronic component not to fall below the manufacturer guarantee temperature.

Note that, in the first to third embodiments, the temperature detection is always performed while the power swing is on. However, the temperature detection can be performed at every fixed time. By always performing the temperature detection, it is possible to realize precise temperature control. However, there is a problem in that a steep rise in power consumption is caused. However, by performing the temperature detection at every fixed time, the problem is solved and the power consumption is reduced. Furthermore, in the third embodiment, a power supply circuit is separately provided only for the temperature sensor 13. Only the temperature sensor 13 is driven even when the power supply is off. When temperature falls below temperature T₃ determined in advance, the air conditioner can be switched to a preliminary warming mode to drive the heater or the power supply IC. The temperature T₃ is set to temperature lower than the guarantee temperature T_{w} of the manufacturer.

In the first to third embodiments, the air conditioner including the indoor unit and the outdoor unit is explained. The air conditioner main body is explained as the outdoor unit. However, in an air conditioner in which an indoor unit and an outdoor unit are integrated, the air conditioner main body refers to an air conditioner having an integrated structure.

The configuration explained in the embodiments indicates an example of contents of the present invention.

### Reference Signs List

1 outdoor unit
2 indoor unit
10 control board
11 power-supply circuit unit
11S indoor-unit power-supply circuit unit
12 microcomputer
13 temperature sensor
14 heater
15 temperature control unit
20 inverter board
21 semiconductor module
22 control unit
30 controller
50 compressor

## Claims

1. An air-conditioner control system comprising:
a power-supply circuit unit (11);
a control board (10) mounted with an electronic component including a microcomputer (12) for control;
a temperature sensor (13) that measures temperature of the electronic component; and
**characterized in that** the air-conditioner control system further comprises an air conditioner main body (1) including an air conditioning function; and
a temperature control unit (15) that heats, during normal operation including a normal operation state and a normal stop state, on the basis of a measurement value of the temperature sensor (13), the electronic component such that operation is performed at temperature equal to or higher than a guarantee temperature of the electronic component.

2. The air-conditioner control system according to claim 1, wherein the temperature control unit (15) includes a heater (14) that heats the electronic component.

3. The air-conditioner control system according to claim 1, wherein the temperature control unit (15) controls a load connected to the air conditioner main body (1) to thereby make it possible to perform the operation at the temperature equal to or higher than the guarantee temperature of the electronic component.

4. The air-conditioner control system according to any one of claims 1 to 3, wherein the temperature sensor (13) performs temperature detection at every time interval determined in advance.

5. The air-conditioner control system according to any one of claims 1 to 4, wherein, while the power-supply circuit unit (11) is ON,
the temperature sensor(13) continues temperature detection of the electronic component, and
the temperature control unit (15) increases a driving current for a circuit, which supplies electric power to an indoor unit, on the basis of a temperature difference between a detected temperature of the temperature sensor (13) and the guarantee temperature to increase the temperature difference to be equal to or larger than a value determined in advance and maintains the electronic component at the temperature equal to or higher than the guarantee temperature.

6. The air-conditioner control system according to any one of claims 1 to 4, wherein
the temperature control unit (15) sets reservation of operation time and, during an operation stop, stops temperature detection of the electronic component and performs control to raise the temperature of the electronic component to be equal to or higher than the guarantee temperature at the reserved time.

7. A control method for controlling an air conditioner using an air-conditioner control system including:
a power-supply circuit unit (11);
a control board (10) mounted with an electronic component including a microcomputer (12) for control; and
a temperature sensor (13) that measures temperature of the electronic component,
**characterized in that** the air conditioner control system further includes an air conditioner main body (1) including an air conditioning function; and
the control method comprising a temperature control step for heating, during normal operation including a normal operation state and a normal stop state, on the basis of a measurement value of the temperature sensor (13), the electronic component such that operation is performed at temperature equal to or higher than a guarantee temperature of the electronic component.

8. The control method for the air conditioner according to claim 7, wherein the temperature control step includes a step for driving a heater (14) that heats the electronic component.

9. The control method for the air conditioner according to claim 7, wherein the temperature control step includes a step of controlling a load connected to the air conditioner main body (1) to thereby make it possible to perform the operation at the temperature equal to or higher than the guarantee temperature of the electronic component.

10. The control method for the air conditioner according to any one of claims 7 to 9, wherein the temperature control step includes a step of performing temperature detection at every time interval determined in advance.

11. The control method for the air conditioner according to any one of claims 7 to 10, wherein
while the power-supply circuit unit (11) is ON, the temperature sensor (13) continues temperature detection of the electronic component,
and
the temperature control step includes a control step for increasing a driving current for a circuit, which supplies electric power to an indoor unit, on the basis of a temperature difference between a detected temperature of the temperature sensor (13) and the guarantee temperature to increase the temperature difference to be equal to or larger than a value determined in advance and maintaining the electronic component at the temperature equal to or higher than the guarantee temperature.

12. The control method for the air conditioner according to any one of claims 7 to 10, wherein
the air conditioner includes an operation reservation timer that reserves operation time, and
the temperature control step includes a step of, during an operation stop, stopping temperature detection of the electronic component and performing control to raise the temperature of the electronic component to be equal to or higher than the guarantee temperature at the time reserved for operation.

## Patentansprüche

1. Klimaanlagensteuersystem, umfassend:
eine Leistungsversorgungsschaltungseinheit (11);
eine Steuerplatine (10), die mit einer elektronischen Komponente, umfassend einen Mikrocomputer (12) zur Steuerung, bestückt ist;
einen Temperatursensor (13), der Temperatur der elektronischen Komponente misst; und
**dadurch gekennzeichnet, dass** das Klimaanlagensteuersystem ferner einen Klimaanlagenhauptkörper (1), aufweisend eine Klimatisierungsfunktion, umfasst; und
eine Temperatursteuereinheit (15), die, während normalen Betriebs, umfassend einen normalen Betriebszustand und einen normalen Stoppzustand, auf der Grundlage eines Messwerts des Temperatursensors (13), die elektronische Komponente erwärmt, derart, dass Betrieb bei einer Temperatur gleich wie oder höher als eine gewährleistete Temperatur der elektronischen Komponente durchgeführt wird.

2. Klimaanlagensteuersystem nach Anspruch 1, wobei die Temperatursteuereinheit (15) einen Erwärmer (14) umfasst, der die elektronische Komponente erwärmt.

3. Klimaanlagensteuersystem nach Anspruch 1, wobei die Temperatursteuereinheit (15) eine mit dem Klimaanlagenhauptkörper (1) verbundene Last steuert, es dadurch möglich zu machen, den Betrieb bei der Temperatur gleich wie oder höher als die gewährleistete Temperatur der elektronischen Komponente durchzuführen.

4. Klimaanlagensteuersystem nach einem der Ansprüche 1 bis 3, wobei der Temperatursensor (13) Temperaturerfassung bei jedem im Voraus bestimmten Zeitintervall durchführt.

5. Klimaanlagensteuersystem nach einem der Ansprüche 1 bis 4, wobei, während die Leistungsversorgungsschaltungseinheit (11) AN ist,
der Temperatursensor (13) Temperaturerfassung der elektronischen Komponente fortsetzt, und
die Temperatursteuereinheit (15) einen Betriebsstrom für eine Schaltung, welche einer Inneneinheit elektrische Leistung zuführt, erhöht auf der Grundlage einer Temperaturdifferenz zwischen einer erfassten Temperatur des Temperatursensors (13) und der gewährleitsteten Temperatur, um die Temperaturdifferenz zu erhöhen, so dass sie gleich ist wie oder größer ist als ein im Voraus bestimmter Wert, und die elektronische Komponente bei der Temperatur gleich wie oder höher als die gewährleistete Temperatur hält.

6. Klimaanlagensteuersystem nach einem der Ansprüche 1 bis 4, wobei
die Temperatursteuereinheit (15) Reservierung von Betriebszeit einstellt, und, während eines Betriebsstopps, Temperaturerfassung der elektronischen Komponente stoppt und Steuerung durchführt, um die Temperatur der elektronischen Komponente zu erhöhen, so dass sie gleich ist wie oder höher ist als die gewährleistete Temperatur bei der reservierten Zeit.

7. Steuerverfahren zum Steuern einer Klimaanlage unter Verwendung eines Klimaanlagensteuersystems, umfassend:
eine Leistungsversorgungsschaltungseinheit (11);
eine Steuerplatine (10), die mit einer elektronischen Komponente, umfassend einen Mikrocomputer (12) zur Steuerung, bestückt ist; und
einen Temperatursensor (13), der eine Temperatur der elektronischen Komponente misst,
**dadurch gekennzeichnet, dass** das Klimaanlagensteuersystem ferner einen Klimaanlagenhauptkörper (1), aufweisend eine Klimatisierungsfunktion, umfasst; und
das Steuerverfahren einen Temperatursteuerschritt zum Erwärmen, während normalen Betriebs, umfassend einen normalen Betriebszustand und einen normalen Stoppzustand, auf der Grundlage eines Messwerts des Temperatursensors (13), der elektronischen Komponente, derart, dass Betrieb bei Temperatur gleich wie oder höher als eine gewährleistete Temperatur der elektronischen Komponente durchgeführt wird, umfasst.

8. Steuerverfahren für die Klimaanlage nach Anspruch 7,
wobei der Temperatursteuerschritt einen Schritt zum Betreiben eines Erwärmers (14) umfasst, der die elektronische Komponente erwärmt.

9. Steuerverfahren für die Klimaanlage nach Anspruch 7,
wobei der Temperatursteuerschritt einen Schritt des Steuerns einer mit dem Klimaanlagenhauptkörper (1) verbundenen Last umfasst, um es dadurch möglich zu machen, den Betrieb bei der Temperatur gleich wie oder höher als die gewährleistete Temperatur der elektronischen Komponente durchzuführen.

10. Steuerverfahren für die Klimaanlage nach einem der Ansprüche 7 bis 9, wobei der Temperatursteuerschritt einen Schritt des Durchführens von Temperaturerfassung bei jedem im Voraus bestimmten Zeitintervall umfasst.

11. Steuerverfahren für die Klimaanlage nach einem der Ansprüche 7 bis 10, wobei
während die Leistungsversorgungsschaltungseinheit (11) AN ist, der Temperatursensor (13) Temperaturerfassung der elektronischen Komponente fortsetzt, und
der Temperatursteuerschritt einen Steuerschritt zum Erhöhen eines Betriebsstroms für eine Schaltung umfasst, welche einer Inneneinheit elektrische Leistung zuführt, auf der Grundlage einer Temperaturdifferenz zwischen einer erfassten Temperatur des Temperatursensors (13) und der gewährleisteten Temperatur, um die Temperaturdifferenz zu erhöhen, so dass sie gleich ist wie oder größer ist als ein im Voraus bestimmter Wert, und Halten der elektronischen Komponente bei der Temperatur gleich wie oder höher als die gewährleitstete Temperatur.

12. Steuerverfahren für die Klimaanlage nach einem der Ansprüche 7 bis 10, wobei
die Klimaanlage einen Betriebsreservierungstimer umfasst, der eine Betriebszeit reserviert, und
der Temperatursteuerschritt einen Schritt des, während eines Betriebsstopps, Stoppens von Temperaturerfassung der elektronischen Komponente und des Durchführens von Steuerung, um die Temperatur der elektronischen Komponente zu erhöhen, so dass sie gleich ist wie oder höher ist als die gewährleistete Temperatur bei der für Betrieb reservierten Zeit, umfasst.

## Revendications

1. Système de commande de climatiseur comprenant :
une unité circuit d'alimentation (11);
une carte de commande (10) montée avec un composant électronique qui comprend un micro-ordinateur (12) de commande ;
un détecteur de la température (13) qui mesure la température du composant électronique ; et
**caractérisé en ce que** le système de commande du climatiseur comprend en outre un corps principal de climatiseur (1) qui comprend une fonction de climatisation ; et
une unité commande de la température (15) qui chauffe, au cours d'un fonctionnement normal qui comprend un état de fonctionnement normal et un état d'arrêt normal, sur la base d'une valeur de mesure du détecteur de la température (13), le composant électronique de telle sorte que le fonctionnement soit exécuté à une température égale ou supérieure à la température de garantie du composant électronique.

2. Système de commande de climatiseur selon la revendication 1, dans lequel l'unité commande de température (15) comprend un dispositif de chauffage (14) qui chauffe le composant électronique.

3. Système de commande de climatiseur selon la revendication 1, dans lequel l'unité commande de température (15) commande une charge connectée au corps principal de climatiseur (1) de façon à lui permettre de ce fait d'exécuter le fonctionnement à la température égale ou supérieure à la température de garantie du composant électronique.

4. Système de commande de climatiseur selon l'une quelconque des revendications 1 à 3, dans lequel le détecteur de la température (13) exécute une détection de la température à chaque intervalle de temps déterminé à l'avance.

5. Système de commande de climatiseur selon l'une quelconque des revendications 1 à 4, dans lequel, tandis que l'unité circuit d'alimentation (11) est en service :
le détecteur de la température (13) continue de détecter la température du composant électronique ; et
l'unité commande de la température (15) accroît le courant de commande d'un circuit, qui fournit l'alimentation à une unité intérieure, sur la base de la différence de température entre la température détectée du détecteur de la température (13), et la température de garantie, de façon à accroître la différence de température de façon à ce qu'elle soit égale ou supérieure à une valeur déterminée à l'avance, et maintient le composant électronique à la température égale ou supérieure à la température de garantie.

6. Système de commande de climatiseur selon l'une quelconque des revendications 1 à 4, dans lequel l'unité commande de la température (15) établit une réservation de temps de fonctionnement et, au cours d'un arrêt de fonctionnement, cesse de détecter la température du composant électronique, et exécute une commande visant à élever la température du composant électronique de façon à ce qu'elle soit égale ou supérieure à la température de garantie lors du temps réservé.

7. Procédé de commande destiné à commander un climatiseur en utilisant un système de commande de climatiseur qui comprend :
une unité circuit d'alimentation (11);
une carte de commande (10) montée avec un composant électronique qui comprend un micro-ordinateur (12) de commande ; et
un détecteur de la température (13) qui mesure la température du composant électronique ;
**caractérisé en ce que** le système de commande du climatiseur comprend en outre un corps principal de climatiseur (1) qui comprend une fonction de climatisation ; et
le procédé de commande comprend une étape de commande de la température consistant à chauffer, au cours d'un fonctionnement normal qui comprend un état de fonctionnement normal et un état d'arrêt normal, sur la base d'une valeur de mesure du détecteur de température (13), le composant électronique de telle sorte que le fonctionnement soit exécuté à une température égale ou supérieure à la température garantie du composant électronique.

8. Procédé de commande du climatiseur selon la revendication 7, dans lequel l'étape de commande de la température, comprend une étape consistant à commander un dispositif de chauffage (14) qui chauffe le composant électronique.

9. Procédé de commande du climatiseur selon la revendication 7, dans lequel l'étape de commande de la température comprend une étape consistant à commander une charge connectée au corps principal de climatiseur (1) de façon à lui permettre de ce fait d'exécuter le fonctionnement à la température égale ou supérieure à la température de garantie du composant électronique.

10. Procédé de commande du climatiseur selon l'une quelconque des revendications 7 à 9, dans lequel l'étape de commande de la température comprend une étape de commande consistant à exécuter une détection de la température à chaque intervalle de temps déterminé à l'avance.

11. Procédé de commande du climatiseur selon l'une quelconque des revendications 7 à 10, dans lequel, tandis que l'unité circuit d'alimentation (11) est en service :
le détecteur de la température (13) continue de détecter la température du composant électronique ; et
l'étape de commande de la température comprend une étape de commande consistant à accroître le courant de commande d'un circuit, qui fournit l'alimentation à une unité intérieure, sur la base de la différence de température entre la température détectée du détecteur de la température (13), et la température de garantie, de façon à accroître la différence de la température de façon à ce qu'elle soit égale ou supérieure à une valeur déterminée à l'avance, et à maintenir le composant électronique à la température égale ou supérieure à la température de garantie.

12. Procédé de commande du climatiseur selon l'une quelconque des revendications 7 à 10, dans lequel :
le climatiseur comprend un temporisateur de réservation de fonctionnement qui réserve un temps de fonctionnement ; et
l'étape de commande de la température comprend une étape consistant, au cours d'un arrêt de fonctionnement, à cesser de détecter la température du composant électronique, et à exécuter une commande visant à élever la température du composant électronique de façon à ce qu'elle soit égale ou supérieure à la température de garantie lors du temps réservé de fonctionnement.
